# EUROPÄISCHE PATENTSCHRIFT

(11) **EP 2 334 161 B1**
(45) Veröffentlichungstag und Bekanntmachung des Hinweises auf die Patenterteilung: **20.02.2019**
(21) Anmeldenummer: 10194455.1
(22) Anmeldetag: 10.12.2010
(51) Int. Cl.: H05K 7/20, H01L 23/40, H01L 23/367

(54) **Steuergerät**
Control unit
Appareil de commande

(30) Priorität: 14.12.2009 DE 102009054585
(43) Veröffentlichungstag der Anmeldung: 15.06.2011
(73) Patentinhaber: Robert Bosch GmbH, 70442 Stuttgart (DE)
(72) Erfinder: Lippok, Ralf, 71522 Backnang (DE)

(56) Entgegenhaltungen:
- DE-A1- 2 722 142
- DE-A1- 19 701 731
- US-A- 5 838 542
- US-A1- 2006 273 137
- US-A1- 2008 068 805
- US-B1- 6 421 240

## Beschreibung

### Stand der Technik

DE 92 00 624 U1 beschreibt ein Steuergerät, umfassend ein mehrteiliges Gehäuse mit Gehäusedeckel und Gehäuseboden, wobei in dem Innenraum eine mit elektronischen Schaltungen bestückte Leiterplatte angeordnet ist. Zur Abführung, der von den Schaltungen erzeugten Wärme, wird das Gehäuse genutzt. Hierfür liegen kragenförmige Randbereiche des Gehäusedeckels und Gehäusebodens jeweils im Bereich des Außenrandes der Leiterplatte auf dieser auf. Allerdings ist die von leistungsstarken Schaltungen erzeugte Verlustwärme derart groß, dass sie über den beschriebenen Entwärmungspfad nur unzureichend abgeführt werden kann.

Aus DE 197 01 731 A1 ist ebenfalls bekannt, ein mehrteiliges Gehäuse eines Steuergerätes als Kühlkörper zu nutzen. Das als Kühlkörper fungierende mehrteilige Gehäuse, welches flächig mit den im Innenraum befindlichen Leistungsbauelementen evtl. über Wärmeleitmassen in Kontakt steht, kann an seiner Außenseite, insbesondere an einem Gehäusedeckel, mit zusätzlichen Mitteln zur Wärmeableitung versehen werden. So wird eine Verbindung zu einer Wärmesenke, beispielsweise einem Karosserieblech, über Befestigungslaschen hergestellt. Des Weiteren ist bekannt, an der Außenseite des Gehäuses Kühlrippen zur Wärmeabfuhr durch Konvektion vorzusehen oder eine zusätzliche Wärmesenke, die an einer Außenseite des Gehäuses angeordnet ist. Das mehrteilige Gehäuse ist nicht standardisiert.

Aus DE 199 10 500 A1 ist bekannt, dass bei einem Steuergerät mit einer in einem Gehäuse angeordneten Leiterplatte, auf der elektrische/elektronische Bauelemente auf einer ersten Seite angeordnet sind und mit Leiterbahnen auf der zweiten Seite der Leiterplatte angeordneten Leiterbahnen elektrisch leitend verbunden sind, Kühlkörperelemente auf der zweiten Seite der Leiterplatte in thermischen Kontakt mit den Leiterbahnen stehen. Zusätzlich ist das Gehäuse mit einer Wärmeleitenden und elektrisch isolierenden Vergussmasse gefüllt, um einen thermischen Kontakt bereitzustellen. Die Bestückung mit Kühlkörperelementen macht einen individuellen Herstellungsprozess des Steuergerätes notwendig, welches eine Kostenerhöhung nach sich zieht.

US 5,838,542 A bezieht sich auf eine Prozessoranordnung mit einer Wärmesenke und einem EMI/ESD-Käfig. Der Prozessor umfasst einen Schaltkreis auf dem der Prozessor montiert ist. Der Schaltkreis enthält eine erste und eine zweite Anzahl von Befestigungselementen. Eine metallische Platte umfasst eine dritte und eine vierte Anzahl von Befestigungselementen. Die dritte Anzahl von Befestigungselementen erfolgt mit der ersten Anzahl von Befestigungselementen zusammen zur Befestigung und thermischen Kopplung des Prozessors an die metallische Platte, so dass diese als eine Basis zur weiteren thermischen Kopplung des Prozessors mit einer Wärmesenke darstellt. Die Rückwand umfasst eine fünfte Anzahl von Befestigungselementen, welche mit der zweiten Anzahl von Befestigungselementen des Schaltkreises und der vierten Anzahl von Befestigungselementen der metallischen Platte zusammenwirken derart, dass die metallische Platte und die Rückwand physisch und elektromagnetisch einen faradayschen Käfig bilden.

DE 27 22 142 A1 bezieht sich auf eine metallische Gehäusewandung für ein elektronische Bauelemente aufnehmendes Gehäuse. Die metallische Gehäusewandung dient als Montage- und Kühlfläche für thermisch hochbelastete Halbleiterbauelemente. Die Innenfläche und die Außenfläche der Gehäusewandung dienen als Anlagefläche für Kühlkörperelemente, wobei beide Flächen mindestens jeweils zwei parallele Montagenuten zur Aufnahme von Klemmstücken aufweisen, die zur Schraubbefestigung der Kühlkörperelemente vorgesehen sind.

Nachteilig bei den aus dem Stand der Technik bekannten Steuergeräten ist, dass die Art und Anzahl der elektrischen/elektronischen Bauelemente auf einem Schaltungsträger je nach Einsatzgebiet des Steuergerätes variieren und somit die abzuführende Wärmemenge zu einem individuellen Bedarf an Kühlkörperelementen führt. Eine standardisierte Herstellung eines Steuergerätes ist demnach nicht möglich. Die oben beschriebenen Maßnahmen, um ein Steuergerät mit ausreichenden Mitteln zur Entwärmung auszustatten, können sich mit zunehmender Integrationsdichte von elektrischen/elektronischen Bauelementen und dem so verursachten Temperaturanstieg als unzureichend erweisen.

### Offenbarung der Erfindung

Der erfindungsgemäß vorgeschlagene Lösung folgend, wird ein Steuergerät mit einem Gehäuse bereitgestellt, in dessen Innenraum mindestens eine Leiterplatte angeordnet ist, die mit mindestens einem Verlustwärme erzeugenden Leistungsbauelement bestückt ist, wobei das Gehäuse zur Wärmeabführung der Verlustwärme in thermischen Kontakt mit dem Leistungsbauelement steht, wobei mindestens ein lateraler Bereich des Gehäuses mindestens eine thermisch leitende und mechanisch gekoppelte Schnittstelle aufweist, wobei mindestens ein Kühlkörperelement an der Schnittstelle in einer variablen Position gekoppelt ist, wobei das mindestens eine Kühlkörperelement an einer Außenseite mindestens eine thermisch leitende Kopplungsstelle bereitstellt, an welche ein weiteres Kühlkörperelement ankoppelbar ist und die mindestens eine thermisch leitende Kopplungsstelle des mindestens einen Kühlkörperelements einen Form-, Kraft- und/oder Stoffschluss mit weiteren Kühlkörperelementen bildet, die als Wärmesenkenanordnung ausgeführt sind. Bekannt ist für die Abführung der Verlustwärme, die im Betrieb des Steuergerätes insbesondere durch die integrierten Leistungsbauelemente erzeugt wird, neben separaten Kühlkörperelementen auch das Gehäuse des Steuergerätes als Kühlfläche zu nutzen. Hierbei ist es gemäß des Standes der Technik bekannt, im Innern des Steuergerätes Maßnahmen bereitzustellen, beispielsweise Wärmeleitmassen, um die Verlustwärme entlang eines Übertragungsweges mit einem niedrigen thermischen Widerstand an das Gehäuse des Steuergerätes abzuführen.

Gemäß der vorliegenden Erfindung wird zunächst eine Grundform des Steuergerätes in einem standarisierten Fertigungsablauf hergestellt, wobei ein Steuergerät mit einem sehr flexiblen Aufbau realisiert werden kann. Es können eine hohe Kompaktheit und Leistungsfähigkeit der Grundform des Steuergerätes erreicht werden, da der Innenraum des Steuergerätes bestückt werden kann, ohne dass separate Kühlkörperelemente berücksichtigt werden müssen. Die Grundform des Steuergerätes umfasst in einem Gehäuse mindestens eine Leiterplatte mit mindestens einem Leistungsbauelement, wobei eine Wärme leitende Kontaktierung der Verlustwärme erzeugenden Elemente zu dem Gehäuse des Steuergerätes vorgesehen ist.

Die Anordnung der Leistungsbauelemente kann beispielsweise auf beiden Seiten der Leiterplatte erfolgen, wodurch ein Gewinn an Fläche erreicht wird. Ferner ergeben sich eine Kostenersparnis und ein hoher Grad an Kompaktheit. Die Leistungsbauelemente sind auf der Leiterplatte frei platzierbar und können in allen Lagen mit den Leiterbahnen verdrahtet werden. Die Leistungsbauelemente können auch nahe einer Steckeranordnung fixiert werden, wodurch nur relativ kurze elektrische Leitungen notwendig sind. Die Leistungsbauelemente können ferner unter Berücksichtigung ihrer elektromagnetischen Verträglichkeit untereinander auf den Seiten der Leiterplatte gruppiert werden. Somit können Steuergeräte konzipiert werden mit einer hohen Dichte an leistungsfähigen elektrischen/elektronischen Leistungsbauelementen unter Ausnutzung des zur Verfügung stehenden Innenraums eines Steuergerätes, ohne dass in den Innenraum des Steuergerätes zu integrierende Kühlkörper zu berücksichtigen sind. Der thermisch leitende Kontakt der Verlustwärme erzeugenden Leistungsbauelemente zu dem Gehäuse, welches seinerseits als Kühlfläche genutzt wird, kann gemäß den aus dem Stand der Technik bekannten Maßnahmen direkt oder über eine Leistungsbauelemente umschließende Wärmeleitmassen erfolgen. Die von den Leistungsbauelementen erzeugte Verlustwärme kann über mehrere Wärmeableitpfade mit einem geringen thermischen Widerstand an das Gehäuse des Steuergerätes abgeführt werden.

Die Grundform des Steuergerätes umfasst ferner eine elektrische Kontaktierung der Leiterplatte. Hierbei kann eine Steckeranordnung in senkrechter oder in waagrechter Anordnung vorgesehen sein. Eine elektrische Kontaktierung kann ebenfalls über direkt an der Leiterplatte angeordnete Kontaktelemente erfolgen oder über direkt ins Layout integrierte Kontakte, beispielsweise eine Direktsteckeranordnung.

Die Grundform des Steuergerätes umfasst ebenfalls ein Gehäuse aus einem Wärme leitenden Material, welches einteilig gestaltet sein kann. Das Gehäuse kann alternativ auch mehrteilig ausgeführt sein, insbesondere einen Gehäuseboden und einen Gehäusedeckel umfassen, welche mittels Kleben, Löten, Bördeln oder einer Schraub-, Rast-, Klemm- oder ähnlichen Verbindungsanordnung miteinander verbunden sind. Der Innenraum des Steuergerätes ist gegen die Umgebung, beispielsweise über ein Dichtmittel abgedichtet. Eine geeignete Materialwahl für das Gehäuse des Steuergerätes verbessert den Wärmeübergang zwischen Leiterplatte und Gehäuse und die Wärmeableitung von dem Gehäuse in die Umgebung. Vorteilhaft ist das Gehäuse als Gussteil auszuführen, wobei eine eloxierte Oberfläche gegenüber einer blanken Oberfläche eine verbesserte Wärmestrahlung zeigt.

Ausgehend von der Grundform des Steuergerätes erfolgt eine Weiterentwicklung desselben, um eine effektive Entwärmung des Steuergerätes zu erzielen. Eine modulare Weiterentwicklung, welche zu einer individuellen Gestaltung des Steuergerätes führt, ist insbesondere vorteilhaft. Die abzuführende Wärme, welche durch Verlustwärme der im Innenraum integrierten Leistungsbauelemente erzeugt und an das Gehäuse des Steuergerätes übertragen wird, wird an der Außenseite des Gehäuses des Steuergerätes über Wärmestrahlung, Wärmeleitung und Konvektion in die Umgebung abgeführt. An mindestens einem lateralen Bereich des Gehäuses ist erfindungsgemäß mindestens eine thermisch leitende und mechanisch ankoppelbare Schnittstelle bereitgestellt, wobei mindestens ein Kühlkörperelement in einer variablen Position ankoppelbar ist. Die mindestens eine thermisch leitende und mechanisch ankoppelbare Schnittstelle an mindestens einem lateralen Bereich des Gehäuses stellt einen Bereich bereit, an dem ein Kühlkörperelement in einer frei wählbaren, variablen Position angekoppelt werden kann. Eine frei wählbare Positionierung eines separaten Kühlkörperelements erlaubt eine Anordnung des Kühlkörperelements in unmittelbarer Nähe zu den Verlustwärme erzeugenden Leistungsbauelementen und so einen kurzen Entwärmungspfad. Erfindungsgemäß vorgesehen ist ein Form- und/oder Kraftschluss, beispielsweise ausgebildet als eine Schraub-, Niet-, Rast- oder Klemmverbindung.

Erfindungsgemäß kann in dem mindestens einen lateralen Bereich des Gehäuses die Schnittstelle in Form gleichmäßig oder ungleichmäßig verteilter Kopplungselemente bereitgestellt werden. Beispielsweise eignet sich ein Bohrmuster, so dass in dem vorgesehenen Bereich das separate Kühlkörperelement mittels entsprechend korrespondierender Befestigungselemente weitgehend beliebig angeordnet und angekoppelt werden kann. Alternativ können Bohrlanglöcher vorgesehen sein, wobei das zu befestigende Kühlkörperelement in eine gewünschte Position innerhalb des Bereichs angeordnet und befestigt wird. Eine beispielsweise als Schwalbenschwanzführung ausgebildete Schnittstelle stellt ebenso eine gewisse variable Anordnung bereit.

Alternativ kann ein entsprechend gestalteter Flächenbereich in einem lateralen Bereich des Gehäuses als Schnittstelle bereitgestellt sein, in dem das mindestens eine separate Kühlkörperelement eingelassen und/oder über eine Löt- oder Klebeverbindung befestigt wird.

Das mindestens eine Kühlkörperelement weist mindestens eine entsprechend korrespondierende Schnittstelle auf, die mit der bereitgestellten thermisch leitenden und mechanisch ankoppelbaren Schnittstelle des Gehäuses verbindbar ist. Die mindestens eine thermisch leitende und mechanisch ankoppelbare Schnittstelle an dem Gehäuse, korrespondierend mit der Schnittstelle des mindestens einen Kühlkörperelements, stellt eine Verbindung bereit, so dass Wärmeenergie vom Gehäuse des Steuergerätes an das mindestens eine Kühlkörperelement mit einem niedrigen thermischen Übertragungswiderstand übergeht. Das mindestens eine Kühlkörperelement kann ausgewählt werden aus einer Vielzahl von Formen und Funktionsprinzipien, um eine optimale Wärmeableitung bereitzustellen, wobei keine Modifikation der Grundform des Steuergerätes notwendig ist.

Erfindungsgemäß kann das Kühlkörperelement an mindestens einem lateralen Bereich eine thermisch leitende Kopplungsstelle bereitstellen, an welche weitere Kühlkörperelemente ankoppelbar sind. Die von einem Kühlkörperelement bereitgestellte thermisch leitende Kopplungsstelle stellt einen Form-, Kraft- oder Stoffschluss mit weiteren Kühlkörperelementen bereit.

Ausgehend von der Grundform des Steuergerätes, welche in einem einfachen, kostengünstigen Fertigungsverfahren hergestellt wird, erfolgt die modulare Weiterentwicklung des Steuergerätes unter Berücksichtigung der Erfordernisse, die sich aus der abzuführenden Wärmeenergie, den baulichen und thermischen Einbaubedingungen und eventuell vorhandenen Anschlüssen in der Einbauumgebung ergeben. So kann ein leistungsfähiges Steuergerät aus unterschiedlichen Modulen, angeordnet in unterschiedlichen Richtungen, kostengünstig aufgebaut werden. Die mindestens eine thermisch leitende und mechanisch ankoppelbare Schnittstelle, die mit einer entsprechend gestalteten Schnittstelle des mindestens einen Kühlkörperelements korrespondiert, erlaubt eine individuell angepasste Fertigstellung des Steuergerätes auf kostengünstige Weise.

Der modulare Aufbau des Steuergerätes ermöglicht es, die Umgebungsbedingungen zu berücksichtigen. Beispielsweise kann der zur Verfügung stehende Bauraum des Steuergerätes optimal genutzt werden, wobei thermisch leitende und mechanisch ankoppelbare Schnittstellen an einem oder mehreren lateralen Bereichen des Gehäuses vorgesehen sind, welche je nachdem welcher Bauraum für den Einbau des fertig gestellten Steuergerätes zur Verfügung steht, bestückt wird. Ferner können nicht nur an dem Gehäuse des Steuergerätes mehrere Kühlkörperelemente angeordnet werden, sondern auch an den bereits angekoppelten Kühlkörperelementen weitere Kühlkörperelement angekoppelt werden.

Das mindestens eine Kühlkörperelement, welches zur Wärmeableitung an das Gehäuse eines Steuergerätes thermisch leitend, mechanisch ankoppelbar ist, ist beispielsweise ein Lüfter, eine Wärmesenke und/oder eine Wärmesenke, die durch die Einbauumgebung zur Verfügung gestellt ist, beispielsweise ein Karosserieblech in einem Fahrzeug. Des Weiteren kann das mindestens eine Kühlkörperelement ein Flüssigkühler sein, welcher ein von einem Fluid durchströmtes u-förmiges oder i-förmiges Wärmerohrsystem umfasst. Eine Kombination mehrerer Kühlkörperelemente, welche an mehreren lateralen Bereichen des Gehäuses des Steuergerätes an den thermisch leitenden, mechanisch ankoppelbaren Schnittstellen angeordnet werden, stellen thermische Parallelpfade bereit, über die Wärme effektiv abgeführt werden kann. Ferner bietet eine Kombination unterschiedlicher Kühlkörperelemente die Möglichkeit, die Wärmeabführung an die Umgebung mit unterschiedlichen thermischen Prinzipien zu erreichen.

Das Steuergerät, welches in einer Grundform vorliegt, wird mit Kühlkörperelementen an einem oder mehreren lateralen Bereichen des Gehäuses des Steuergerätes bestückt. Hierfür stehen thermisch leitende und mechanisch ankoppelbare Schnittstellen an den lateralen Bereichen des Gehäuses des Steuergerätes und an den entsprechenden Bereichen der Kühlkörperelemente zur Verfügung. Denkbare Kombinationen an Kühlkörperelementen sind eine Wärmesenkenanordnung beispielsweise an oberem und/oder unterem lateralen Bereich des Steuergerätes, ein Lüfter an oberem und/oder unterem lateralen Bereich des Steuergerätes, ein Flüssigkühler an oberem und/oder unterem lateralen Bereich des Steuergerätes. Kombiniert werden können beispielsweise ein Lüfter und ein Flüssigkühler oder eine Wärmesenkenanordnung. Ebenso können eine Wärmesenkenanordnung und ein Flüssigkühler an einem Steuergerät thermisch leitend an lateralen Bereichen mechanisch angekoppelt sein. Durch die modulare Weiterentwicklung des Steuergerätes steht eine Varianz der Steuergeräte zur Verfügung, wobei zusätzliche Kühlkörperelementen an den thermisch leitenden und mechanisch ankoppelbaren Schnittstellen an dem Gehäuse kostengünstig und vorteilhaft werkzeuglos angekoppelt werden. Kombiniert werden können ferner Kühlkörperelemente an den thermisch leitenden und mechanisch ankoppelbaren Schnittstellen am Steuergerät mit nachgeordneten Kühlkörperelementen, welche an den angekoppelten Kühlkörperelementen angeordnet werden. Beispielsweise kann eine mit dem Steuergerät verbundene Wärmesenkenanordnung kombiniert werden mit einem Lüfter und/oder einem Flüssigkühler. So kann einem Anstieg der Temperatur aufgrund einer gesteigerten Integrationsdichte an leistungsstarken Leistungsbauelementen durch zusätzliche Kühlkörperelemente begegnet werden, ohne dass eine Sonderanfertigung des Steuergerätes mit den damit verbundenen Kosten erforderlich ist.

### Kurze Beschreibung der Zeichnungen

Anhand der Zeichnung wird die Erfindung nachstehend eingehender beschrieben.

Es zeigt:
- Figur 1: eine Grundform eines Steuergerätes mit auf einer Leiterplatte angeordneten Leistungsbauelementen, einer Steckeranordnung und einem Gehäuse;
- Figur 2: ein mehrteiliges Gehäuse mit thermisch leitenden und mechanisch ankoppelbaren Schnittstellen, kombiniert mit einer Wärmesenkenanordnung und einem Lüfter;
- Figur 3: ein mehrteiliges Gehäuse mit thermisch leitenden und mechanisch ankoppelbaren Schnittstellen, kombiniert mit Flüssigkühlern;
- Figur 4: Steuergerät mit thermisch leitenden und mechanisch ankoppelbaren Schnittstellen, kombiniert mit einer Wärmesenkenanordnung und einem Flüssigkühler;
- Figur 5: Steuergerät mit thermisch leitenden und mechanisch ankoppelbaren Schnittstellen, kombiniert mit einem Lüfter und einem Flüssigkühler.
- Figur 6: Steuergerät mit thermisch leitender und mechanisch ankoppelbaren Schnittstellen, kombiniert mit einem Flüssigkühler und einer Wärmesenkenanordnung, kombiniert mit einem Lüfter.

### Ausführungsformen

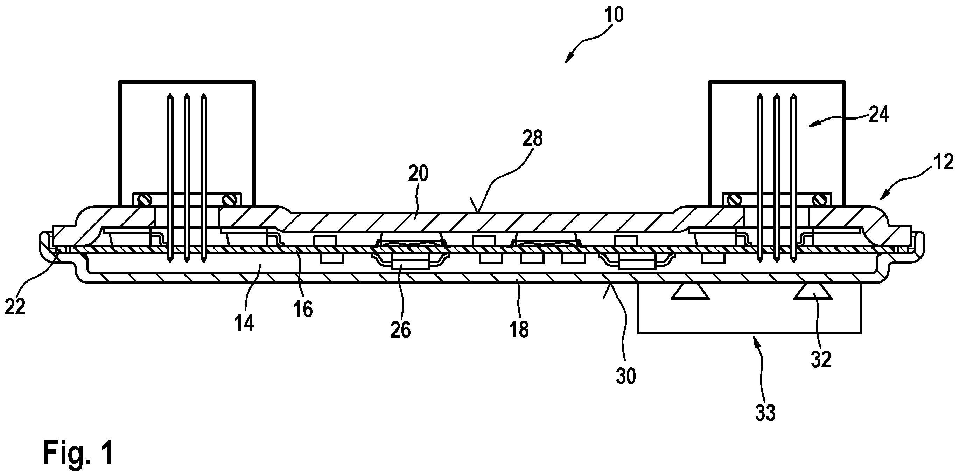

Der Darstellung gemäß Figur 1 ist in schematischer Widergabe ein Steuergerät (10) in einer Grundform zu entnehmen.

Das Steuergerät (10) weist ein Gehäuse (12) auf, in dessen Innenraum (14) eine Leiterplatte (16) angeordnet ist. Als Leiterplatte (16) können ein- oder mehrlagige Leiterplatten aus Kunststoff zum Einsatz kommen. Alternativ kann auch eine Folie aus Kunststoff oder aus einem Keramikmaterial eingesetzt werden. Das Gehäuse (12) des Steuergerätes (10) kann einteilig oder auch mehrteilig ausgebildet sein. Es besteht aus einem Gehäuseboden (18) und einem Gehäusedeckel (20), welche die Leiterplatte (16) umschließen. Das Gehäuse (12) ist aus einem wärmeleitenden Material gefertigt, beispielsweise Stahlblech oder Aluminium. Ein einteiliges Gehäuse (12) umfasst an einer Seite eine Einschuböffnung, in die die Leiterplatte eingeschoben werden kann und welche dann verschlossen wird. Bei einem mehrteiligen Gehäuse (12) sind Gehäuseboden (18) und Gehäusedeckel (20) auf einer nicht näher dargestellten Weise, beispielsweise mittels Schraub-, Rast-, Klemm- oder ähnlicher Verbindungsanordnung miteinander verbunden, wobei ein Dichtungselement (22) dazwischen liegend vorgesehen ist, um den umschlossenen Innenraum (14) gegen die Umgebung abzudichten. Alternativ können die Gehäuseteile (18, 20) miteinander aber auch durch Kleben, Löten, Bördeln oder Nieten verbunden sein.

An dem Gehäuse (12) kann eine Steckeranordnung (24) vorgesehen, die zur Leiterplatte (16) auf nicht dargestellte Weise eine elektrische Verbindung zur Signalübertragung bereitstellt.

Die im Innenraum (14) angeordnete Leiterplatte (16) ist mit Leistungsbauelementen (26) vorzugsweise beidseitig bestückt, die in der Figur 1 nur vereinfacht dargestellt sind. Die Leistungsbauelemente (26) sind mittels Lot mit der Leiterplatte (16) bzw. mit einer nicht dargestellten elektrischen Schaltung verbunden. Alternativ sind die Leistungsbauelemente (26) mittels einer elektrisch leitfähigen Klebeverbindung mit der elektrischen Schaltung kontaktiert. Die Leistungsbauelemente (26), welche im Betrieb eine Verlustwärme erzeugen, umfassen unter anderem eine wärmeableitende Fläche, beispielsweise in Form eines Metallplättchens. Das Metallplättchen kontaktiert über Lot die Leiterplatte (16), wobei die auf diese abgeleitete Wärme mittelbar oder unmittelbar auf das Gehäuse (12) abgeführt wird. In dem Wärmeübertragungsweg kann ein Wärmeleitmedium eine thermische Anbindung an das Gehäuse (12) bereitstellen.

Die mit den Leistungsbauelementen (26) bestückte Leiterplatte (16) ist in dem Gehäuse (12) derart angeordnet, dass eine möglichst großflächige thermische Ankoppelung an das Gehäuse (12) des Steuergerätes (10) besteht. Die von den Leistungsbauelementen (26) erzeugte Verlustwärme wird mit einem relativ geringen thermischen Widerstand an das Gehäuse (12) abgeführt, wobei mindestens zwei parallele Wärmeableitpfade einerseits zum Gehäusedeckel (20) und andererseits zum Gehäuseboden (18) bereitgestellt werden.

Aus der Darstellung gemäß Figur 1 geht hervor, dass in mindestens einem lateralen Bereich (28, 30) des Gehäuses (12) mindestens eine thermisch leitende und mechanisch ankoppelbare Schnittstelle (32) bereitgestellt ist, an die mindestens ein Kühlkörperelement (33) ankoppelbar ist. Die thermisch leitende und mechanisch ankoppelbare Schnittstelle (32) kann als Schraub-, Niet-, Rast- oder Klemmverbindung ausgeführt sein, mittels der ein entsprechend ausgebildetes Kühlkörperelement (33) in dem mindestens einen lateralen Bereich (28, 30) des Gehäuses (12) angeordnet wird. In der Darstellung gemäß Figur 1 ist die mindestens eine thermisch leitende und mechanisch ankoppelbare Schnittstelle (32) beispielsweise als Schwalbenschwanzführung ausgebildet, in die ohne Verwendung eines Werkzeuges ein Kühlkörperelement (33) mit einer entsprechend gestalteten Aufnahme in einer variablen Position eingeschoben werden kann. Über das mindestens eine zusätzliche Kühlkörperelement (33) wird ein Mittel bereitgestellt, das die Ableitung der Wärme über laterale Bereiche (28, 30) des Gehäuses (12) vorsieht.

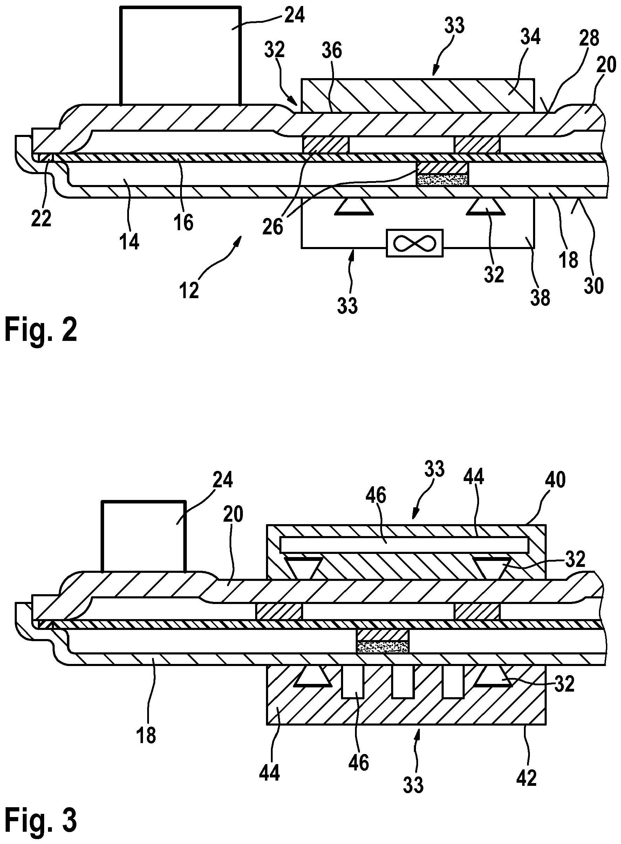

Aus der Darstellung der Figur 2 geht eine Ausführungsform eines erfindungsgemäßen Steuergerätes (10) hervor.

So kann, wie in Figur 2 dargestellt ist, in mindestens einem lateralen Bereich (28, 30) des Gehäuses (12), entweder an dem Gehäuseboden (18) oder dem Gehäusedeckel (20), mindestens eine thermisch leitende und mechanisch ankoppelbare Schnittstelle (32) vorgesehen sein, die mit einer Wärmesenkenanordnung (34) gekoppelt ist. Die Wärmesenkenanordnung (34) kann hierbei als Block ausgebildet sein, beispielsweise mit einem weitgehend rechteckigen Querschnitt. Die mindestens eine thermisch leitende und mechanisch ankoppelbare Schnittstelle (32) stellt in der dargestellten Ausführungsform einen ebenen Flächenbereich (36) an dem Gehäuse (12) bereit, in welchem Kopplungselemente (52) bereitgestellt sind, beispielsweise ein Bohrmuster, welches die Wärmesenkenanordnung (34) mit entsprechenden Elementen (nicht dargestellt) in einer frei wählbaren Position aufnimmt. Das Bohrmuster kann gleichmäßig oder ungleichmäßig verteilte Aufnahmelöcher bereitstellen, wobei auch Langlöcher umfasst sind, welche eine wählbare Positionierung erlauben. Die Wärmesenkenanordnung (34) umfasst eine passive Vorrichtung z.B. eine gezogene Aluminium- oder Kupferplatte mit einer Mehrzahl von Rippen, die thermisch mit dem Gehäuse (12) über die mindestens eine thermisch leitende und mechanisch ankoppelbare Schnittstelle (32) gekoppelt ist, um Wärme von dem Gehäuse (12) zu absorbieren und diese durch Konvektion an die Umgebung abzugeben. Alternativ kann als Wärmesenkenanordnung (34) ein Kühlkörperelement (33) in Form einer Heatpipe eingesetzt werden.

Alternativ kann als Wärmesenkenanordnung (34) eine bereits in der Einbauumgebung des Steuergerätes (10) vorhandene Wärmesenke genutzt werden, welche an das Gehäuse (12) über die mindestens eine thermisch leitende und mechanisch ankoppelbare Schnittstelle (32) ankoppelbar ist. Dabei stellen beispielsweise Karosseriebleche eine derartige Wärmesenke bereit.

Ferner ist in der Figur 2 dargestellt, dass eine weitere thermisch leitende und mechanisch ankoppelbare Schnittstelle (32) in lateralen Bereichen (28, 30) des Gehäuses (12) bereitgestellt ist, so dass beispielsweise sowohl der Gehäuseboden (18) als auch der Gehäusedeckel (20) mit Kühlkörperelementen (33) thermisch leitend verbindbar ist. In dem in Figur 2 dargestellten Ausführungsbeispiel ist ein Lüfter (38) thermisch leitend in dem lateralen Bereich (30) des Gehäuses (12) angeordnet. Der Lüfter (38) umfasst in einem Gehäuse im Allgemeinen Kühlrippen, auf welche die Wärmeenergie abgeleitet wird. Ein erzeugter Luftstrom führt die Wärme von den Kühlrippen ab. Die Kombination mehrerer separater Kühlkörperelemente (33), die nach unterschiedlichen Prinzipien eine Ableitung der von den Leistungsbauelementen (26) erzeugten Wärmeenergie an die Umgebung bereitstellen, erlaubt eine verbesserte Entwärmung des Steuergerätes (10). Ferner nutzt eine Kombination verschiedener separater Kühlkörperelemente (33) an einem Steuergerät (10), z.B. ein Lüfter (38) und eine Wärmesenkenanordnung (34), die in der Einbauumgebung bereitgestellten Anschlüsse und Bedingungen vorteilhaft, wobei beispielsweise ein Stromanschluss, eine Luftzufuhr oder ein Karosserieblech verwendet werden können, so dass die Wärme effektiv abgeleitet wird.

Aus der Darstellung der Figur 3 geht ein alternatives Ausführungsbeispiel eines Steuergerätes (10) hervor.

So sind in den lateralen Bereichen (28, 30) des Gehäuses (12) des Steuergerätes (10) thermisch leitende und mechanisch ankoppelbare Schnittstellen (32) sowohl an dem Gehäuseboden (18) als auch an dem Gehäusedeckel (20) bereitgestellt, die mit separaten Kühlkörperelementen (33), ausgeführt als Flüssigkühler (40, 42), thermisch kombiniert sind. Der Flüssigkühler (40, 42) ist in Figur 3 nur schematisch dargestellt. Der Flüssigkühler (40, 42) umfasst ein Kühlkanalgehäuse (44), in welchem mindestens ein Strömungskanal (46) angeordnet ist, in welchem ein Kühlmedium über einen Einlass eingeleitet und über einen Auslass ausgeleitet wird, welche nicht dargestellt sind. Die Wärme wird von dem Gehäuse (12) des Steuergerätes (10) über die mindestens eine thermisch leitende Schnittstelle (32) an das Kühlkanalgehäuse (44) abgeleitet und durch Konvektion auf das Kühlmedium übertragen. Für das Kühlmedium können in dem Kühlkanalgehäuse (44) ein u-förmiger Strömungsweg oder mehrere parallele Strömungswege bereitgestellt sein mit konstantem oder veränderlichem Strömungsquerschnitt. Flüssigkühler (40, 42) werden über die thermisch, leitenden, standardisierten Schnittstellen (32) mit dem Steuergerät (10) kombiniert, wobei vorteilhaft in der Umgebung vorhandene Kühlkreisläufe genutzt werden können.

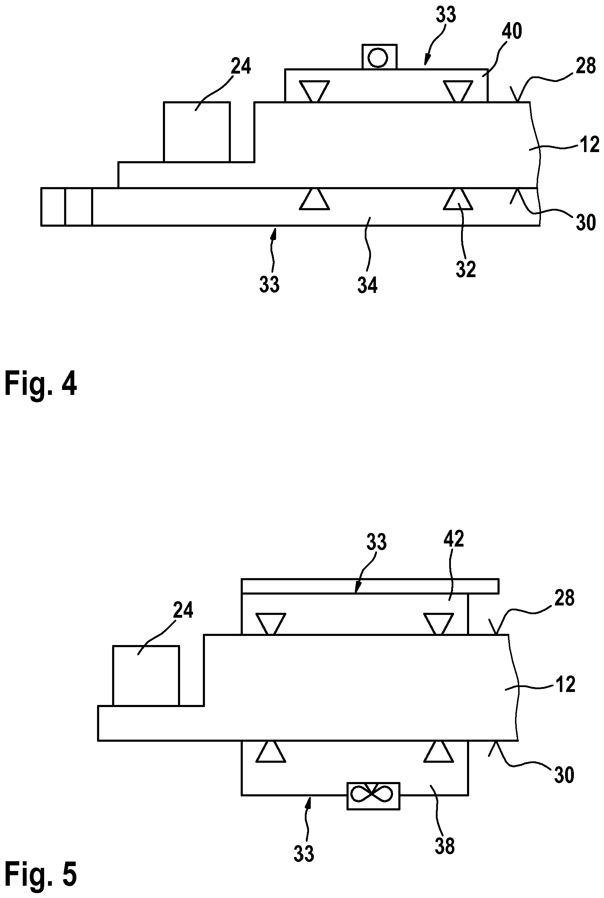

Aus den nur schematischen Darstellungen der Figuren 4 und 5 gehen weitere Ausführungsformen hervor, die Kombinationen von separaten Kühlkörperelementen (33) mit einem Steuergerät (10) darstellen. Die Wahl geeigneter separater Kühlkörperelemente (33), welche die von den Leistungsbauelementen (26) erzeugte und auf das Gehäuse (12) abgeleitete Wärmeenergie an die Umgebung über Wärmeleitung, Wärmestrahlung oder Konvektion abgeben, richtet sich nach den baulichen und klimatischen Einbaubedingungen des Steuergerätes (10) aber auch nach der von den integrierten Leistungsbauelementen (26) erzeugten Wärmeenergie. Der für das Steuergerät (10) zur Verfügung stehende Bauraum kann es erforderlich machen, dass das mit Kühlkörperelementen (33) bestückte Steuergerät (10) möglichst flach ist, so dass möglicherweise nur in einem lateralen Bereich (28, 30) des Gehäuses (12) ein zusätzliches Kühlkörperelement (33) angeordnet werden kann. Des Weiteren kann in der Einbauumgebung des Steuergerätes (10) ein Kreislauf eines Kühlmediums vorteilhaft genutzt werden, so dass Flüssigkühler (40, 42) in einem oder mehreren lateralen Bereichen (28, 30) des Gehäuses (12) angeordnet werden, möglicherweise kombiniert mit einem zusätzlichen Kühlkörperelement (33) wie einer Wärmesenkenanordnung (34), dargestellt in Figur 4, oder einem Lüfter (38), dargestellt in Figur 5. Ebenso werden in der Einbauumgebung vorhandene Stromanschlüsse genutzt. Kombinationen unterschiedlicher Kühlkörperelementen (33) in lateralen Bereichen (28, 30) des Gehäuses (12) des Steuergerätes (10), beispielsweise Wärmesenkenanordnungen (34) oder Lüfter (38) unterschiedlichen Typs oder Flüssigkühler (40, 42) mit einer differierenden Kühlmediumführung, werden mit dem erfindungsgemäß vorgeschlagenen Steuergerät (10) über die zur Verfügung stehenden thermisch leitenden und mechanisch ankoppelbaren Schnittstellen (32) einfach und kostengünstig erreicht. Alternativ können mehrere Kühlkörperelemente (33) in lateralen Bereichen (28, 30) des Gehäuses (12) angekoppelt werden.

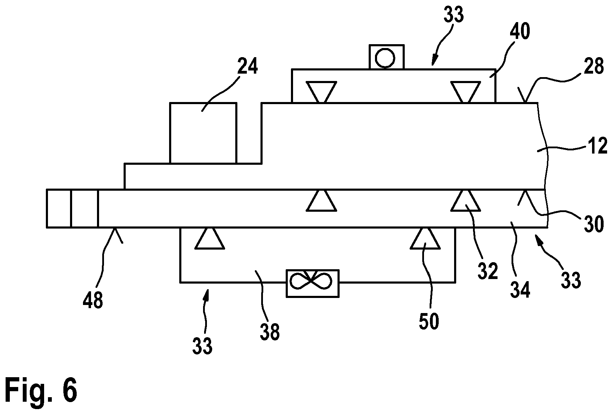

In Figur 6 ist eine weitere Kombination eines erfindungsgemäßen Steuergerätes (10) dargestellt, wobei zusätzlich zu den über die thermisch leitenden und mechanisch ankoppelbaren Schnittstellen (32) in lateralen Bereichen (28, 30) des Gehäuses (12) angekoppelten Kühlkörperelemente (33), ausgebildet als Flüssigkühler (40) und als Wärmesenkenanordnung (34), ein weiteres Kühlkörperelement (33), ausgeführt als Lüfter (38) an einer Außenseite (48) des angekoppelten Kühlkörperelements (34) über thermisch leitende Kopplungselemente (50) angeordnet ist.

Mit dem erfindungsgemäß vorgeschlagenen Steuergerät (10) ist eine Abführung der innerhalb des Steuergerätes (10) durch die integrierten Leistungsbauelemente erzeugte Verlustwärme an die Umgebung möglich. Die mittels eines oder mehrerer optimierter Wärmeleitpfade von den Leistungsbauelementen (26) auf das Gehäuse (12) abgeleitete Wärmeenergie wird an die Umgebung über parallele Pfade abgeführt, wobei verschiedene Prinzipien nebeneinander vorhanden sind. Beispielsweise erfolgt die Entwärmung mittels Konvektion, Wärmeleitung und/oder Wärmestrahlung und Kombinationen daraus, bereitgestellt durch zusätzliche separate Kühlkörperelemente (33). Damit verringert sich der Wärmewiderstand des Steuergerätes (10). Die Ableitung der Verlustwärme wird maximiert, so dass die durch die Verlustwärme bedingten Ausfälle des Steuergerätes (10) erheblich verringert werden. Die Zuverlässigkeit des Steuergerätes (10) wird erhöht. Durch die nachträgliche Bestückung einer standarisierten Grundform des Steuergerätes (10) über mindestens eine thermisch leitende und mechanisch ankoppelbare Schnittstelle (32) mit geeigneten Kühlkörperelementen (33) ist eine Modifikation des Steuergerätes (10) ohne höhere Herstellungskosten möglich. Insbesondere vorteilhaft ist, dass auf die Umgebung des eingebauten Steuergerätes (10) Rücksicht genommen wird und bereits vorhandene Anschlüsse genutzt werden.

## Patentansprüche

1. Steuergerät (10), umfassend ein Gehäuse (12), in dessen Innenraum (14) mindestens eine Leiterplatte (16) angeordnet ist, die mit mindestens einem Verlustwärme erzeugenden Leistungsbauelement (26) bestückt ist, wobei das Gehäuse (12) zur Wärmeabführung der Verlustwärme in thermischen Kontakt mit dem Leistungsbauelement (26) steht, wobei mindestens ein lateraler Bereich (28, 30) des Gehäuses (12) mindestens eine thermisch leitende und mechanisch gekoppelte Schnittstelle (32) aufweist, wobei mindestens ein Kühlkörperelement (33) an der Schnittstelle (32) in einer variablen Position gekoppelt ist, **dadurch gekennzeichnet, dass** das mindestens eine Kühlkörperelement (33) an einer Außenseite (48) mindestens eine thermisch leitende Kopplungsstelle (50) bereitstellt, an welche ein weiteres Kühlkörperelement (33) ankoppelbar ist und die mindestens eine thermisch leitende Kopplungsstelle (50) des mindestens einen Kühlkörperelements (33) einen Form-, Kraft- und/oder Stoffschluss mit weiteren Kühlkörperelementen (33) bildet, die als Wärmesenkenanordnung (34) ausgeführt sind.

2. Steuergerät (10) gemäß Anspruch 1, **dadurch gekennzeichnet, dass** das mindestens eine Kühlkörperelement (33) mittels eines Form- und/oder Kraftschlusses an der mindestens einen thermisch leitenden und mechanisch Schnittstelle (32) gekoppelt ist.

3. Steuergerät (10) gemäß Anspruch 2, **dadurch gekennzeichnet, dass** die mindestens eine thermisch leitende und mechanisch gekoppelte Schnittstelle (32) eine Schraub-, Niet-, Rast- oder Klemmverbindung ist.

4. Steuergerät (10) gemäß Anspruch 1, **dadurch gekennzeichnet, dass** die mindestens eine thermisch leitende und mechanisch gekoppelte Schnittstelle (32) in dem mindestens einen lateralen Bereich (28, 30) gleichmäßig oder ungleichmäßig verteilte Kopplungselemente (52) bereitstellt.

5. Steuergerät (10) gemäß Anspruch 4, **dadurch gekennzeichnet, dass** die Koppelungselemente (52) in Form gleichmäßig oder ungleichmäßig verteilter Bohrlöcher bereitgestellt sind.

6. Steuergerät (10) gemäß Anspruch 1, **dadurch gekennzeichnet, dass** ein weiteres Kühlkörperelement (33) an der thermisch leitenden und mechanisch ankoppelbaren Schnittstelle (32) und/oder an der thermisch leitenden Kopplungsstelle (50) angekoppelt ist/sind.

7. Steuergerät (10) gemäß Anspruch 1, **dadurch gekennzeichnet, dass** die Wärmesenkenanordnung (34) eine in der Einbauumgebung vorhandene Wärmesenke ist.

8. Steuergerät (10) gemäß Anspruch 1, **dadurch gekennzeichnet, dass** das mindestens eine Kühlkörperelement (33) ein Lüfter (38) ist.

9. Steuergerät (10) gemäß Anspruch 1, **dadurch gekennzeichnet, dass** das mindestens eine Kühlkörperelement (33) ein Flüssigkühler (40, 42) ist.

## Claims

1. Controller (10), comprising a housing (12), at least one printed circuit board (16) being arranged in the interior (14) of the said housing and the said printed circuit board being populated with at least one power component (26) which generates heat losses, wherein the housing (12) is in thermal contact with the power component (26) for the purpose of dissipating the heat losses, wherein at least one lateral region (28, 30) of the housing (12) has at least one thermally conductive and mechanically coupled interface (32), wherein at least one cooling body element (33) is coupled to the interface (32) in a variable position, **characterized in that** the at least one cooling body element (33) provides at least one thermally conductive coupling point (50) on an outer side (48), it being possible for a further cooling body element (33) to be coupled to said coupling point, and the at least one thermally conductive coupling point (50) of the at least one cooling body element (33) forms an interlocking, force-fitting and/or materially bonded connection with further cooling body elements (33) which are embodied as a heat sink arrangement (34).

2. Controller (10) according to Claim 1, **characterized in that** the at least one cooling body element (33) is coupled to the at least one thermally conductive and mechanically interface (32) by means of an interlocking and/or force-fitting connection.

3. Controller (10) according to Claim 2, **characterized in that** the at least one thermally conductive and mechanically coupled interface (32) is a screw, rivet, latching or clamping connection.

4. Controller (10) according to Claim 1, **characterized in that** the at least one thermally conductive and mechanically coupled interface (32) provides uniformly or non-uniformly distributed coupling elements (52) in the at least one lateral region (28, 30).

5. Controller (10) according to Claim 4, **characterized in that** the coupling elements (52) are provided in the form of uniformly or non-uniformly distributed bore holes.

6. Controller (10) according to Claim 1, **characterized in that** a further cooling body element (33) is/are coupled to the thermally conductive and mechanically couplable interface (32) and/or to the thermally conductive coupling point (50).

7. Controller (10) according to Claim 1, **characterized in that** the heat sink arrangement (34) is a heat sink which is present in the installation environment.

8. Controller (10) according to Claim 1, **characterized in that** the at least one cooling body element (33) is a fan (38).

9. Controller (10) according to Claim 1, **characterized in that** the at least one cooling body element (33) is a liquid-cooled radiator (40, 42).

## Revendications

1. Contrôleur (10), comprenant un boîtier (12) dans l'espace intérieur (14) duquel est disposé au moins un circuit imprimé (16), lequel est équipé d'au moins un composant de puissance (26) produisant des déperditions de chaleur, le boîtier (12) se trouvant en contact thermique avec le composant de puissance (26) en vue de la dissipation thermique des déperditions de chaleur, au moins une zone latérale (28, 30) du boîtier (12) possédant au moins une interface (32) à conduction thermique et couplée mécaniquement, au moins un élément dissipateur de chaleur (33) étant couplé au niveau de l'interface (32) dans une position variable, **caractérisé en ce que** l'au moins un élément dissipateur de chaleur (33) fournit au niveau d'un côté extérieur (48) au moins un point de couplage (50) à conduction thermique au niveau duquel peut être couplé un élément dissipateur de chaleur (33) supplémentaire, et l'au moins un point de couplage (50) à conduction thermique de l'au moins un élément dissipateur de chaleur (33) formant un assemblage par complémentarité de formes, de force et/ou par fusion de matières avec l'élément dissipateur de chaleur (33) supplémentaire, lequel est réalisé sous la forme d'un arrangement puits thermique (34).

2. Contrôleur (10) selon la revendication 1, **caractérisé en ce que** l'au moins un élément dissipateur de chaleur (33) est couplé à l'au moins une interface (32) à conduction thermique et mécaniquement au moyen d'un assemblage par complémentarité de formes et/ou de force.

3. Contrôleur (10) selon la revendication 2, **caractérisé en ce que** l'au moins une interface (32) à conduction thermique et couplée mécaniquement est un assemblage par vissage, rivetage, encliquetage ou serrage.

4. Contrôleur (10) selon la revendication 1, **caractérisé en ce que** l'au moins une interface (32) à conduction thermique et couplée mécaniquement fournit des éléments de couplage (52) distribués de manière régulière ou irrégulière dans l'au moins une zone latérale (28, 30) .

5. Contrôleur (10) selon la revendication 4, **caractérisé en ce que** les éléments de couplage (52) sont fournis sous la forme de trous percés distribués de manière régulière ou irrégulière.

6. Contrôleur (10) selon la revendication 1, **caractérisé en ce qu'**un élément dissipateur de chaleur (33) supplémentaire est/sont couplé/couplés à l'interface (32) à conduction thermique et couplée mécaniquement et/ou au point de couplage (50) à conduction thermique.

7. Contrôleur (10) selon la revendication 1, **caractérisé en ce que** l'arrangement puits thermique (34) est un puits thermique présent dans l'environnement d'installation.

8. Contrôleur (10) selon la revendication 1, **caractérisé en ce que** l'au moins un élément dissipateur de chaleur (33) est un ventilateur (38).

9. Contrôleur (10) selon la revendication 1, **caractérisé en ce que** l'au moins un élément dissipateur de chaleur (33) est un radiateur à liquide (40, 42).
